# DEMANDE DE BREVET EUROPEEN

(11) **EP 4 167 144 A1**
(43) Date de publication de la demande: **19.04.2023**
(21) Numéro de dépôt: 22199722.4
(22) Date de dépôt: 05.10.2022
(51) Int. Cl.: G06N 3/063, G06F 30/30, G06N 3/12, G06N 3/10, G06N 3/04, G06N 3/08

(54) **METHODE DE CONCEPTION D'UNE ARCHITECTURE MATERIELLE OPTIMISEE POUR L'EXECUTION D'UN RESEAU DE NEURONES**

(30) Priorité: 14.10.2021 FR 2110880
(71) Demandeur: Commissariat à l'énergie atomique et aux énergies alternatives, 75015 Paris (FR); Universite De Bretagne Sud, 56100 Lorient (FR)
(72) Inventeur: ALI, Nermine, 91191 GIF-SUR-YVETTE Cedex (FR); PHILIPPE, Jean-Marc, 91190 GIF-SUR-YVETTE (FR); TAIN, Benoît, 91191 GIF-SUR-YVETTE Cedex (FR); COUSSY, Philippe, 56270 PLOEMEUR (FR)
(74) Mandataire: Atout PI Laplace

(57) **Abrégé**

L'invention concerne une méthode mise en œuvre par ordinateur de génération d'une architecture matérielle de circuit numérique pour l'exécution d'un réseau de neurones artificiels comprenant: la réception d'un descripteur du réseau de neurones ; une pluralité d'itération des étapes suivantes : la génération d'une description de haut niveau de l'architecture matérielle sous forme de code informatique, prenant en entrée ladite description du réseau de neurone ; l'optimisation d'au moins un paramètre de configuration de ladite description de haut niveau, en fonction d'une estimation d'au moins un critère de performance d'une architecture matérielle obtenue à partir du code de haut niveau ; la conversion du code de haut niveau en architecture matérielle de circuit numérique.

## Description

### Domaine de l'invention

La présente invention concerne le domaine des réseaux de neurones, et plus particulièrement le domaine de la conception des architectures matérielles de calcul optimisées pour l'exécution des réseaux de neurones.

### Etat de l'art précédent.

Les réseaux de neurones artificiels sont de plus en plus utilisés dans des applications variées. Ils sont composés d'un certain nombre de neurones nécessitant des opérations mathématiques. Certain de ces réseaux de neurones sont organisés en couches successives, les neurones d'une couche étant reliés à la couche suivante. Parmi ceux-ci, les réseaux de neurones profonds, ou DNN (de l'anglais Deep Neural Networks, ou réseaux de neurones profonds), et en particulier les réseaux de neurones convolutifs, ou CNN (de l'anglais Convolutional Neural Networks, ou Réseaux de Neurones Convolutifs) sont caractérisés par une complexité importante, due au nombre important et à la taille élevée des couches pouvant être mises en jeu. L'augmentation du nombre et de la taille des couches augmente donc la quantité d'opérations mathématiques mises en œuvre, et donc le temps d'exécution d'un réseau.

Les topologies des réseaux de neurones varient fortement d'un réseau à un autre. Ceci induit des complexités calculatoires, ainsi que des besoins mémoires, très variables d'un réseau de neurones à un autre.

De très nombreuses architectures matérielles peuvent permettre d'exécuter un même réseau de neurones. Les architectures matérielles peuvent par exemple être des architectures ASIC (de l'anglais Application Specific Integrated Circuit, en français circuit intégré spécifique à une application) ou FPGA (de l'anglais Field Programmable Gate Array, en français réseau de portes logiques programmables sur site).

La conception d'une architecture matérielle permettant de coder un réseau de neurones est une tâche extrêmement longue et complexe. De plus, les différentes architectures matérielles permettant d'exécuter un même réseau de neurones ont des caractéristiques extrêmement différentes en termes de performance, mémoire, taille de puce, etc. De fait, en plus d'être extrêmement longues, les techniques usuelles de conception d'architectures matérielles pour l'exécution des réseaux de neurones aboutissent généralement à des résultats non optimisés en termes de performances.

L'approche dite « Magnet », décrite par Venkatesan, R., Shao, Y. S., Wang, M., Clemons, J., Dai, S., Fojtik, M., ... & Khailany, B. (2019, November). Magnet: A modular accelerator generator for neural networks. In 2019 IEEE/ACM International Conference on Computer-Aided Design (ICCAD) (pp. 1-8). IEEE. utilise un générateur d'architecture matérielle pour l'exécution d'un réseau de neurones basé sur un patron (en anglais, template) d'architecture spécifique. Dans l'approche "Magnet", un réseau de neurone donné est porté sur une instance du patron d'architecture, et le flot de l'approche propose d'optimiser certains paramètres matériels du patron de l'architecture dans une boucle afin de respecter des critères de performance.

L'approche « Magnet » ne permet cependant qu'une optimisation limitée. En particulier, l'utilisation d'un patron d'architecture prédéfini limite les capacités d'optimisation.

Il y a donc besoin d'une méthode de conception d'une architecture matérielle pour l'exécution d'un réseau de neurones, permettant à la fois une conception rapide de l'architecture à partir du réseau de neurones, tout en optimisant l'architecture vis-à-vis d'un ou plusieurs critères.

### Résumé de l'invention.

A cet effet, l'invention a pour objet une méthode mise en œuvre par ordinateur de génération d'une architecture matérielle de circuit numérique pour l'exécution d'un réseau de neurones artificiels comprenant: la réception d'un descripteur du réseau de neurones ; une pluralité d'itération des étapes suivantes : la génération d'une description de haut niveau de l'architecture matérielle sous forme de code informatique, prenant en entrée ladite description du réseau de neurone ; l'optimisation d'au moins un paramètre de configuration de ladite description de haut niveau, en fonction d'une estimation d'au moins un critère de performance d'une architecture matérielle obtenue à partir de la description de haut niveau ; la conversion de la description de haut niveau en architecture matérielle de circuit numérique.

Avantageusement, la méthode comprend, préalablement à une première itération de ladite pluralité d'itérations, une étape de détermination d'au moins une caractéristique du réseau de neurones, et dans laquelle l'étape de génération de la description de haut niveau lors de la première itération prend également en entrée ladite au moins une caractéristique du réseau de neurones.

Avantageusement, l'estimation de l'au moins un critère de performance est effectuée, pour au moins une itération, en convertissant la description de haut niveau en une architecture matérielle de circuit numérique, puis en déterminant les valeurs de l'au moins un critère sur l'architecture matérielle.

Avantageusement, l'estimation de l'au moins un critère de performance est effectuée, pour au moins une itération, par l'application d'un modèle de performance à la description de haut niveau.

Avantageusement, la valeur de l'au moins un paramètre de configuration de ladite description de haut niveau est définie, lors de l'optimisation, met en œuvre un algorithme génétique.

Avantageusement, un ensemble de configurations est obtenu pour chaque couche par l'application d'un algorithme génétique, puis un algorithme de recherche est utilisé pour déterminer une combinaison optimisée des configurations des couches.

Avantageusement, la méthode comprend, à l'issue de l'étape de conversion de la description de haut niveau en architecture matérielle de circuit numérique, une étape de configuration d'un circuit de calcul à partir de l'architecture matérielle.

L'invention a également pour objet une architecture matérielle pour l'exécution d'un réseau de neurone obtenue par la méthode selon l'un des modes de réalisation de l'invention.

L'invention a également pour objet un circuit numérique implémenté selon l'architecture selon l'invention.

D'autres caractéristiques, détails et avantages de l'invention ressortiront à la lecture de la description faite en référence aux dessins annexés donnés à titre d'exemple et qui représentent, respectivement :

Fig.1 une méthode mise en œuvre par ordinateur de génération d'une architecture matérielle de circuit numérique pour l'exécution d'un réseau de neurones artificiels dans un ensemble de modes de réalisation de l'invention ;

Fig.2 un exemple de méthode mise en œuvre par ordinateur de génération d'une architecture matérielle de circuit numérique pour l'exécution d'un réseau de neurones artificiels dans un ensemble de modes de réalisation de l'invention basés sur une solution de génération par synthèse haut-niveau dite HLS (de l'anglais « High-Level Synthesis », en français « Synthèse de Haut Niveau ») ;

Fig.3 un exemple d'optimisation de couches d'un réseau de neurones dans un ensemble de modes de réalisation de l'invention.

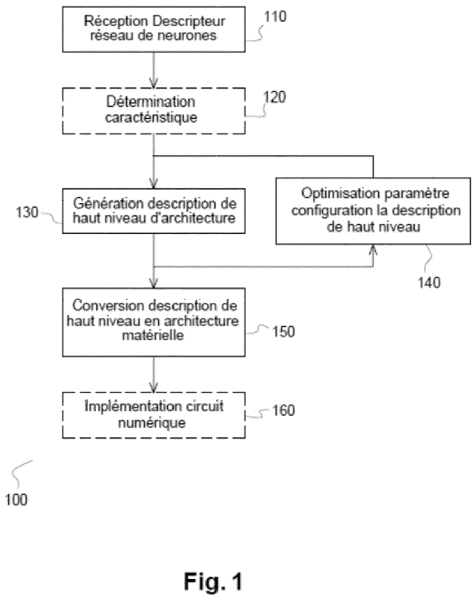

La figure 1 représente une méthode mise en œuvre par ordinateur de génération d'une architecture matérielle de circuit numérique pour l'exécution d'un réseau de neurones artificiels dans un ensemble de modes de réalisation de l'invention.

La méthode 100 est une méthode de génération d'une architecture matérielle de circuit numérique pour l'exécution d'un réseau de neurones artificiels, c'est-à-dire une méthode permettant de générer, à partir d'un réseau de neurones en entrée, une architecture matérielle optimisée pour l'exécution de ce réseau de neurones.

La méthode 100 comprend une première étape 110 de réception d'un descripteur du réseau de neurones.

Le descripteur du réseau de neurones peut comprendre tous les éléments permettant de définir le réseau de neurones, tels que :
- la topologie du réseau ;
- la taille et le type des couches ;
- les poids synaptiques ;
- etc.

Le descripteur du réseau de neurones peut par exemple être contenu dans un fichier. Par exemple, des fichiers de format ONNX (acronyme anglais signifiant « Open Neural Network Exchange », en français « Echange de Réseau de Neurones Ouvert ») ou encore utilisés par des logiciels du type TensorflowLite, ou N2D2 (acronyme anglais signifiant « Neural Network Design and Deployement », en français « Conception et Déploiement de Réseau de Neurones ») peuvent décrire des réseaux de neurones convolutifs.

L'invention est applicable à tous types de réseaux de neurones. Elle est particulièrement adaptée à des réseaux de neurones profonds et/ou des réseaux de neurones convolutifs, car elle permet de générer des architectures matérielles optimisées pour ces types de réseaux de neurones particulièrement complexes.

La méthode 100 comprend ensuite plusieurs itérations :
- d'une étape 130 de génération d'une description de haut niveau de l'architecture sous forme de code informatique, prenant en entrée ladite description du réseau de neurone. Le code informatique peut consister en un langage d'abstraction du matériel ;
- d'une étape 140 d'optimisation d'au moins un paramètre de configuration de ladite description de haut niveau, en fonction d'une estimation d'au moins un critère de performance d'une architecture matérielle obtenue à partir de la description de haut niveau.

Plusieurs itérations des étapes 130 et 140 peuvent ainsi être exécutées successivement.

L'étape 130 consiste à générer, à partir de la description du réseau de neurones, une description haut niveau de l'architecture de calcul, par exemple à base d'un langage d'abstraction du matériel.

Une description haut niveau de l'architecture de calcul permet d'abstraire le matériel et ainsi simplifier son codage (et donc sa génération). Par exemple, dans une approche de type synthèse de haut niveau (HLS), la description haut niveau de l'architecture peut être réalisée par des langages informatiques de type C/C++ représentant les opérations effectuées pour implémenter le réseau de neurones (l'algorithme). Par exemple, le pseudo-code ci-dessous définit une implémentation d'une couche de convolution :

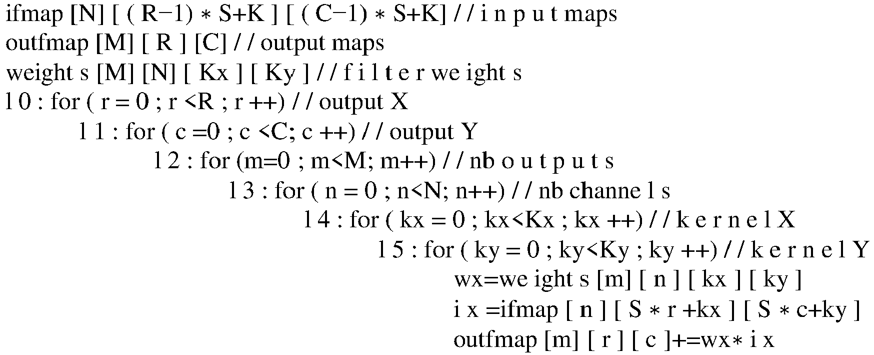

Le code informatique (pouvant notamment consister en un langage d'abstraction de matériel) utilisé pour la description de haut niveau de l'architecture de calcul peut par exemple être, en fonction de l'approche de génération de matériel utilisée :
- Un code C / C++ ;
- Un code Chisel ;
- Un code pyMTL ;
- Un code spinal-HDL ;
- Etc...

Une description de haut niveau de l'architecture peut être paramétrée de différentes manières. Par exemple, un code C/C++ peut être paramétré de différentes manières dans une approche HLS. Par exemple, il peut être paramétré en incluant des « pragma » (instructions spécifiques) qui permettent de définir comment la description de haut niveau va être transformée en code de bas niveau de description de matériel, et donc comment une architecture matérielle est générée à partir de la description de haut niveau. Par exemple, ces paramètres de configuration de la description de haut niveau permettent de définir, lors de la conversion de cette description haut niveau en code bas niveau de description de matériel, quelles boucles logicielles seront transformées selon un déroulage de boucle, un pipelining ou parallélisées. D'autres paramètres de configuration peuvent par exemple correspondre à une définition de boucles à casser, ou intervertir.

Ces différents paramètres de configuration ont donc un impact fort sur l'architecture matérielle obtenue. En particulier, selon ces paramètres, de nombreuses architectures matérielles différentes peuvent être obtenues, impliquant différentes performances, occupation d'espace, besoins mémoires, consommation énergétiques, etc.

De manière générale, compte tenu de la complexité de l'implémentation des réseaux de neurones, et en particulier des réseaux de neurones profonds et/ou convolutifs, la combinatoire des paramètres possibles est extrêmement importante.

Afin d'améliorer la situation, l'étape 140 consiste à optimiser au moins un paramètre de configuration de la description haut niveau du matériel, en fonction d'une estimation d'au moins un critère de performance d'une architecture matérielle obtenue à partir de cette description de haut niveau.

Dit autrement, l'étape 140 consiste à identifier les valeurs de paramètres de configuration permettant d'aboutir à une description de haut niveau générant une architecture matérielle optimisée selon un ou plusieurs de critères.

Dans un ensemble de modes de réalisation de l'invention, les critères d'optimisation comprennent un ou plusieurs critères choisis parmi :
- la puissance de calcul de l'architecture matérielle ;
- la taille de l'architecture matérielle ;
- un ou plusieurs critères de performance, tels que la latence d'exécution, ou l'empreinte mémoire de l'architecture matérielle ;
- la consommation énergétique.

Dans un ensemble de modes de réalisation de l'invention, les critères de performances sont choisis parmi les critères fournis par un rapport de PPA (de l'anglais Power-Performance-Area, en français Puissance-Performance-Surface).

Selon différents modes de réalisation de l'invention, l'optimisation peut être faite sous contrainte (par exemple, avec une surface ou une empreinte mémoire bornée), et un poids plus ou moins important peut être assigné aux différents critères.

Dans un ensemble de modes de réalisation de l'invention, l'estimation de l'au moins un critère de performance est effectuée, pour au moins une itération, en convertissant la description de haut niveau de l'architecture en une architecture matérielle de circuit numérique, puis en déterminant les valeurs de l'au moins un critère sur l'architecture matérielle.

Par exemple, l'architecture matérielle peut être générée, et l'empreinte mémoire et/ou la surface occupée par l'architecture matérielle déterminée directement en appliquant les étapes classiques d'un flot de conception sur l'architecture matérielle sur l'architecture matérielle. Par exemple, les étapes du flot de conception peuvent comprendre la synthèse logique, le placement/routage, etc....

Cette solution a l'avantage de fournir une estimation relativement précise des critères de sélection de l'architecture, mais le temps d'obtention des estimations peut être long.

Dans un ensemble de modes de réalisation de l'invention, l'estimation de l'au moins un critère de performance est effectuée, pour au moins une itération, grâce à l'application d'un modèle de performance sur la configuration d'architecture qui serait générée par la description de haut niveau incluant des paramètres de configurations déterminés.

Le modèle de performance peut ainsi fournir une estimation des performances directement à partir de la configuration de l'architecture avant même sa description en langage de haut niveau, tel que le code C pour une technique HLS. Un tel modèle peut par exemple consister en un modèle théorique, ou un modèle statistique paramétré par simulation.

Ceci permet de bénéficier d'une estimation de l'au moins un critère de performance de manière rapide, car il n'est pas nécessaire d'effectuer de conversion de la description haut niveau en architecture matérielle, et ensuite de réaliser les étapes typique d'un flot de conception (synthèse, placement/routage, etc.). Cette estimation peut cependant être moins précise qu'une estimation basée sur une conversion de la description haut niveau en architecture matérielle.

Dans un ensemble de modes de réalisation de l'invention, les estimations des critères de performances sont effectuées de la même manière pour chaque itération.

Dans d'autres modes de réalisation de l'invention, les estimations des critères de performances sont effectuées de différentes manières, par exemple :
- par l'application d'un modèle de performance à la configuration de l'architecture, sans générer la description haut niveau de celle-ci, pour la plupart des itérations ;
- en convertissant la description haut niveau de l'architecture en une architecture matérielle de circuit numérique, puis en déterminant les valeurs de l'au moins un critère sur l'architecture matérielle, pour certaines itérations (par exemple, une itération sur 10, une itération sur 100).

Ceci permet d'avoir à la fois un résultat globalement rapide, puisque l'estimation de performance est obtenue de la manière la plus rapide pour la plupart des itérations, et précis, puisqu'une estimation précise est obtenue pour certaines itérations.

Pour l'optimisation, la détermination des valeurs de l'au moins un paramètre de configuration peut être effectuée de différentes manières.

De manière générale, l'étape 140 d'optimisation consiste à déterminer les valeurs de l'au moins un paramètre qui optimisent l'au moins un critère de performance.

L'ensemble des valeurs possibles de paramètres (i.e ordre d'exécution des boucles, déroulage, pipelining, parallélisation des boucles, etc.) forment un espace de paramètres.

Une solution dite « force brute » consiste à tester l'ensemble des combinaisons de paramètres possibles, estimer l'au moins un critère de performance pour chaque combinaison, et conserver la combinaison fournissant les critères de performances les plus optimisés.

Cette solution est cependant difficile à mettre en pratique, car la combinatoire des paramètres rend un test exhaustif extrêmement long et coûteux.

Dans un ensemble de modes de réalisation de l'invention, la valeur de l'au moins un paramètre de configuration de ladite description de haut niveau est définie, lors de l'optimisation, par l'application d'un algorithme génétique.

Cette solution peut être mise en pratique en considérant les différents paramètres comme des gènes, et leurs différentes valeurs comme des allèles de l'algorithme génétique.

Cette solution permet d'obtenir une combinaison de paramètres optimisés avec une complexité de calcul raisonnable. De plus l'utilisation d'un algorithme génétique diminue la probabilité de converger vers un optimum local beaucoup moins performant que l'optimum global.

Cependant, cet algorithme génétique est fourni à titre d'exemple uniquement d'un algorithme de définition des valeurs optimisées des paramètres, et d'autres algorithmes, tels que par exemple des algorithmes de machine learning ou autres algorithmes d'optimisation, peuvent être utilisés.

Les itérations des étapes 130 et 140 peuvent être réalisées jusqu'à ce qu'une solution viable soit trouvée (c'est-à-dire, une solution qui permette de satisfaire les contraintes de l'application ou du système cible, par exemple, une taille ou une latence maximale) et/ou jusqu'à ce qu'un niveau d'optimisation cible soit atteint. D'autres critères d'arrêt des itérations peuvent être utilisés. Par exemple, les itérations peuvent être poursuivies tant que l'architecture matérielle est optimisée entre deux itérations.

A l'issue des itérations des étapes 130 et 140, la méthode 100 comprend une étape 150 de conversion de la description de haut niveau en architecture matérielle de circuit numérique.

Cette étape consiste à convertir la description de haut niveau optimisée en une architecture matérielle, par exemple, convertir du code C/C++ modifié en architecture matérielle.

L'architecture matérielle définit de manière exhaustive comment un circuit numérique (par exemple, un FPGA ou un ASIC) doit être implémenté pour exécuter le réseau de neurones.

Selon différents modes de réalisation de l'invention, l'architecture matérielle peut être décrite à différents niveaux. Par exemple, une architecture matérielle peut être décrite au niveau dit RTL (de l'anglais Register Transfer Level, ou Niveau de Transfert de Registres). Une architecture au niveau RTL définit le comportement d'un circuit numérique et peut être directement convertie en portes logiques combinatoires et en éléments séquentiels (bascules, etc...). Un architecture de ce niveau, parfois appelée « architecture de bas niveau », peut par exemple être exprimée dans des langages de description matérielle (en anglais HDL, « Hardware Description Langage) tels que Verilog ou VHDL.

Grâce aux étapes 130 et 140, l'architecture obtenue est optimisée selon le ou les critères désirés (taille de l'architecture, besoins mémoire, performance, etc.). De plus, le temps de définition de l'architecture selon la méthode 100 est faible.

La méthode 100 permet donc de définir rapidement des architectures matérielles optimisées permettant l'exécution d'un réseau de neurones donné.

Dans un ensemble de modes de réalisation de l'invention, la méthode 100 comprend, à l'issue de l'étape de conversion de la description de haut niveau en architecture matérielle de circuit numérique, une étape 160 de configuration d'un circuit de calcul à partir de l'architecture matérielle.

Cette étape 160 consiste à implémenter un circuit de calcul tel qu'un ASIC ou un FPGA, selon l'architecture matérielle. A l'issue de cette étape, le circuit numérique obtenu permet donc de réaliser l'exécution du réseau de neurones, avec les performances optimisées, conformes à l'estimation réalisée à l'étape 140, par exemple par les évaluations haut niveau et/ou le flot de conception classique.

Dans un ensemble de modes de réalisation de l'invention, la méthode 100 comprend, préalablement à une première itération des étapes 130 et 140, une étape 120 de détermination d'au moins une caractéristique d'architecture du réseau de neurones, et l'étape 130 de génération de la description de haut niveau lors de la première itération prend également en entrée ladite au moins une caractéristique du réseau de neurones. L'au moins une caractéristique du réseau de neurones peut concerner l'architecture/topologie du réseau, les paramètres, hyperparamètres, poids du réseau, etc...

Dit autrement, une ou plusieurs caractéristiques du réseau de neurones sont déterminées à partir de la seule définition du réseau de neurones, et la première génération de la description de haut niveau de l'architecture matérielle prend en compte ces caractéristiques.

Les caractéristiques du réseau de neurones peuvent par exemple être :
- Une indication de réutilisation de données. Cette caractéristique est particulièrement importante pour les réseaux de neurones convolutifs, dans lesquels les pixels sont réutilisés par le biais de fenêtre glissantes ;
- Un mapping des couches ;
- Un type de couches ;
- Une taille de couches intermédiaires ;
- Un type de données dans une couche (entiers, flottant...) ;
- Un nombre de coefficients signifiants dans une couche ;
- Un nombre de zéros dans une couche ;
- Etc.

La prise en compte des caractéristiques du réseau de neurones permet d'obtenir, lors de la première itération de l'étape 130 de génération de la description de haut niveau, une description de haut niveau pré-optimisée. Par exemple, les boucles de convolution peuvent être optimisées pour diminuer l'empreinte mémoire de l'architecture, en tirant parti de la réutilisation de pixels entre noyaux convolutifs. Ceci permet d'améliorer l'optimisation de la description, tout en diminuant le nombre d'itérations nécessaires à l'optimisation.

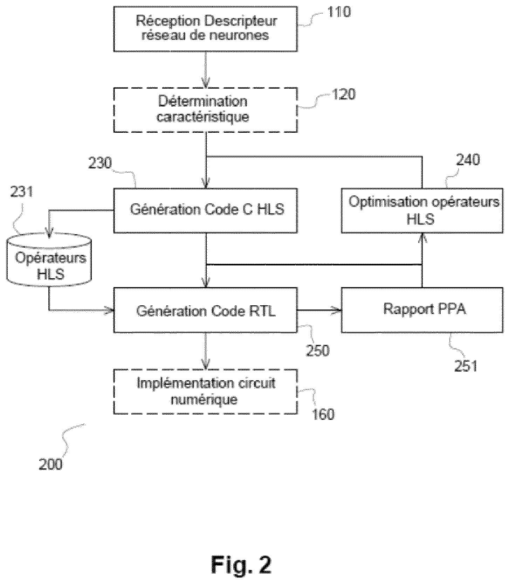

La figure 2 représente un exemple de méthode mise en œuvre par ordinateur de génération d'une architecture matérielle de circuit numérique pour l'exécution d'un réseau de neurones artificiels dans un ensemble de modes de réalisation de l'invention basés sur une solution de génération par synthèse haut-niveau dite HLS (de l'anglais « High-Level Synthesis », en français « Synthèse de Haut Niveau ») .

La méthode 200 est un exemple d'implémentation de la méthode 100, reprenant les étapes de la méthode 100 et en spécifiant certaines. Les étapes 130, 140 et 150 sont notamment remplacées par les étapes 230, 240 et 250 respectivement.

Dans l'étape 230, la description de haut niveau générée est du code C, et à l'étape 250, ce code est converti en code RTL. Les étapes 230 et 250 sont basées sur une technique dite HLS (de l'anglais High-Level Synthesis, ou en français Synthèse de Haut Niveau) décrite notamment par Nane, R., Sima, V. M., Pilato, C., Choi, J., Fort, B., Canis, A., ... & Bertels, K. (2015). A survey and evaluation of FPGA high-level synthesis tools. IEEE Transactions on Computer-Aided Design of Integrated Circuits and Systems, 35(10), 1591-1604. Dans le cadre de la méthode 200, d'au moins un paramètre de configuration de ladite description de haut niveau consiste en au moins un opérateur décrit pour la technique HLS.

Les étapes 230 et 250 se basent sur une bibliothèque 231 d'opérateurs décrits pour la technique HLS. Ces opérateurs décrits pour la technique HLS comprennent notamment des labels associés à des directives (commandes spécifiques), ou « pragmas », permettant d'optimiser la génération d'architecture pour chaque couche. Ces directives peuvent indiquer, au sein du code C, différents types d'optimisation, tels que des partitionnements de tableaux, des déroulages de boucles, etc... Le pseudo code ci-dessous représente un pseudo code d'un opérateur de convolution 3x3. Les opérateurs « #pragma HLS UNROLL » indiquent qu'une boucle doit être déroulée.

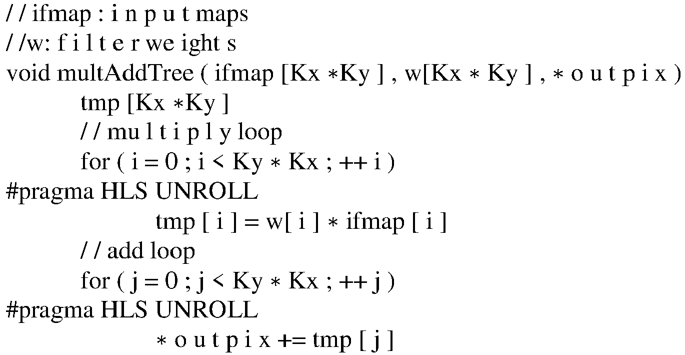

Lors de l'étape 250, le code C intégrant les opérateurs décrits pour la technique HLS est converti en code RTL définissant l'architecture numérique. Les opérateurs décrits pour la technique HLS sont pris en compte pour la génération, permettant d'obtenir une architecture optimisée selon les opérateurs.

Lors de l'étape 240, l'algorithme génétique permet de sélectionner les opérateurs décrits pour la technique HLS les plus pertinents et d'optimiser la description haut niveau de l'architecture matérielle.

L'optimisation peut s'effectuer via une pluralité d'itérations. Les itérations peuvent être réalisées en une seule boucle, ou une pluralité de boucles imbriquées. Les boucles peuvent être organisées selon différents, niveaux reflétant par exemple le niveau de description, le niveau de l'évaluation de performances (modèle, RTL, circuit, etc...).

Par exemple, l'optimisation peut se faire selon une double boucle :
- Pour la plupart des itérations, l'optimisation se fait directement, après génération du code C (description de haut niveau), via un modèle de performances ;
- Pour certaines itérations (par exemple, une itération sur 10 ou 100), le code RTL est généré à l'étape 250, un rapport PPA est généré sur ce code à l'étape 251, et l'optimisation des opérateurs se base sur les prédictions de performance du rapport PPA.

Dans un ensemble de modes de réalisation de l'invention, le modèle de performances comprend :
- Un modèle de surface ;
- Un modèle de latence.

Le modèle de surface peut notamment être défini par une estimation du nombre de DSP, LUT, FF et BRAM requis par un code donné, dans le cas où la cible est un FPGA. Le nombre de DSP peut être évalué, pour chaque boucle, selon qu'elle comprenne des opérateurs, soit déroulée ou soumise à un pipeline.

La latence peut être estimée, dans le modèle de latence, en déterminant récursivement la latence des boucles en partant des boucles les plus profondes.

Dans un ensemble de modes de réalisation, l'optimisation à l'étape 250 met en œuvre un algorithme génétique.

Dans un ensemble de modes de réalisation de l'invention, chaque couche est optimisée séparément, puis l'ensemble du réseau est optimisé.

Par exemple, un ensemble de configurations peut être obtenu pour chaque couche par l'application d'un algorithme génétique, puis un algorithme de recherche est utilisé pour déterminer une combinaison optimisée des configurations des couches.

L'utilisation d'un algorithme génétique permet, pour chaque couche, d'obtenir un ensemble de configurations comprenant des configurations optimisées sensiblement différentes les unes des autres. L'algorithme de recherche permet d'identifier des combinaisons des configurations optimisées, c'est-à-dire permettant de respecter des contraintes définies et/ou d'optimiser un ou des critères de performances. Cette association d'algorithmes génétiques sur les couches, et d'un algorithme de recherche global, permet donc d'identifier une combinaison optimisée parmi une combinatoire très variée.

Dans un ensemble de modes de réalisation de l'invention, l'optimisation d'une couche du réseau de neurones s'effectue en encodant la couche comme un vecteur de N paires de gènes, dans lequel N est le nombre de boucles de la couche. Chaque gène encode une dimension, et a quatre formes d'optimisation :
- Facteur de « tiling », ou « tuilage » : définit si un « tiling » est appliqué à la boucle ;
- Paires de valeurs de pragma : définit si des optimisations telles que l'application d'un pipeline, ou le déroulage de boucle sont appliquées ;
- Opérateurs, pour les boucles internes ;
- Absence d'optimisation.

Les combinaisons des valeurs possibles forment différentes allèles du gène.

Les différentes opérations d'un algorithme génétique (sélection, mutation, crossover...) sont appliquées, et les performances de la couche sont évaluées par un modèle de performance, puis le gène résultant est sélectionné s'il optimise le modèle de performance. Comme expliqué ci-dessus, le modèle de performance peut prendre en compte différents paramètres, et peut notamment comprendre un modèle de surface et un modèle de latence.

La méthode 200 fournit un exemple concret de génération d'une architecture matérielle optimisée, basée sur l'utilisation d'une solution HLS. Cependant, elle est donnée à titre d'exemple non limitatif uniquement, et l'invention est applicable à l'optimisation de code selon des moyens et paramètres autre que ceux fournis par la HLS.

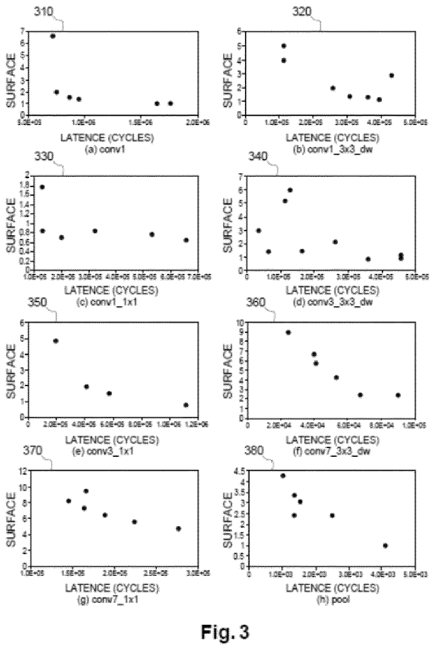

La figure 3 représente un exemple d'optimisation de couches d'un réseau de neurones dans un ensemble de modes de réalisation de l'invention.

Dans l'exemple de la figure 3, 8 couches sont optimisées, représentées par les 8 graphes respectivement :
- Graphe 310, une couche de convolution ;
- Graphe 320, une couche de convolution 3×3 ;
- Graphe 330, une couche de convolution 1×1 ;
- Graphe 340, une couche de convolution 3×3 ;
- Graphe 350, une couche de convolution 1×1 ;
- Graphe 360, une couche de convolution 3x3;
- Graphe 370, une couche de convolution 1×1 ;
- Graphe 380, une couche de regroupement (en anglais pooling layer).

Chaque graphe est représenté sur deux dimensions selon :
- un axe horizontal, représentant la latence, en nombre de cycles, de la couche ;
- un axe vertical, représentant la surface de l'architecture matérielle permettant d'exécuter la couche. La surface peut être calculée comme une somme pondérée des ressources (LUT, FF, DSP, BRAM) du FPGA.

Pour chaque graphe, différentes optimisations possibles sont représentées par des points dont la position définit, pour une optimisation donnée, sa latence et sa surface.

La figure 3 montre que certaines configurations sont plus optimisées que d'autres, mais aussi que, de manière générale, un compromis peut être trouvé entre latence et surface, puisque les configurations les plus petites ne sont pas les plus rapides, et inversement.

Les exemples ci-dessus démontrent la capacité de l'invention à optimiser une architecture matérielle pour l'exécution d'un réseau de neurones artificiels. Ils ne sont cependant donnés qu'à titre d'exemple et ne limitent en aucun cas la portée de l'invention, définie dans les revendications ci-dessous.

## Revendications

1. Méthode mise en œuvre par ordinateur (100) de génération d'une architecture matérielle de circuit numérique pour l'exécution d'un réseau de neurones artificiels comprenant:
- la réception (110) d'un descripteur du réseau de neurones ;
- une pluralité d'itération des étapes suivantes :
∘ la génération (130) d'une description de haut niveau de l'architecture matérielle sous forme de code informatique, prenant en entrée ladite description du réseau de neurone ;
∘ l'optimisation (140) d'au moins un paramètre de configuration de ladite description de haut niveau, en fonction d'une estimation d'au moins un critère de performance d'une architecture matérielle obtenue à partir de la description de haut niveau, laquelle l'estimation de l'au moins un critère de performance est effectuée, pour au moins une itération, par l'application d'un modèle de performance à la description de haut niveau ;
- la conversion (150) de la description de haut niveau en architecture matérielle de circuit numérique.

2. Méthode selon la revendication 1, comprenant, préalablement à une première itération de ladite pluralité d'itérations, une étape (120) de détermination d'au moins une caractéristique du réseau de neurones, et dans laquelle l'étape de génération de la description de haut niveau lors de la première itération prend également en entrée ladite au moins une caractéristique du réseau de neurones.

3. Méthode selon l'une des revendications 1 ou 2, dans laquelle l'estimation de l'au moins un critère de performance est effectuée, pour au moins une itération, en convertissant la description de haut niveau en une architecture matérielle de circuit numérique, puis en déterminant les valeurs de l'au moins un critère sur l'architecture matérielle.

4. Méthode selon l'une quelconque des revendications précédentes, dans laquelle la valeur de l'au moins un paramètre de configuration de ladite description de haut niveau est définie, lors de l'optimisation, met en œuvre un algorithme génétique.

5. Méthode selon la revendication 4, dans laquelle un ensemble de configurations est obtenu pour chaque couche par l'application d'un algorithme génétique, puis un algorithme de recherche est utilisé pour déterminer une combinaison optimisée des configurations des couches.

6. Méthode selon l'une quelconque des revendications précédentes, comprenant, à l'issue de l'étape de conversion de la description de haut niveau en architecture matérielle de circuit numérique, une étape (160) de configuration d'un circuit de calcul à partir de l'architecture matérielle.

7. Architecture matérielle pour l'exécution d'un réseau de neurone obtenue par la méthode selon l'une des revendications 1 à 6.

8. Circuit numérique implémenté selon l'architecture de la revendication 7.
